(19) Europäisches Patentamt / European Patent Office / Office européen des brevets

(11) **EP 1 750 283 B1**

(12) **EUROPÄISCHE PATENTSCHRIFT**

(45) Veröffentlichungstag und Bekanntmachung des Hinweises auf die Patenterteilung:
**22.09.2010 Patentblatt 2010/38**

(51) Int Cl.:
***G11C 29/02*** *(2006.01)*

(21) Anmeldenummer: **06117618.6**

(22) Anmeldetag: **21.07.2006**

(54) **Überprüfung eines Adressdecoders**

Verification of an address decoder

Vérification d'un décodeur d'adresses

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **04.08.2005 DE 102005036728**
**30.01.2006 DE 102006004168**

(43) Veröffentlichungstag der Anmeldung:
**07.02.2007 Patentblatt 2007/06**

(73) Patentinhaber: **ROBERT BOSCH GMBH**
**70442 Stuttgart (DE)**

(72) Erfinder:
- **Boehl, Eberhard**
  **72768 Reutlingen (DE)**
- **Seydel, Gunter**
  **72810 Gomaringen (DE)**
- **Schmidt-Grethe, Karsten**
  **72762 Reutlingen (DE)**

(56) Entgegenhaltungen:
**EP-A- 1 001 432**

- **SACHDEV M: "Test and testability techniques for open defects in RAM address decoders" EUROPEAN DESIGN AND TEST CONFERENCE, 1996. ED&TC 96. PROCEEDINGS PARIS, FRANCE 11-14 MARCH 1996, LOS ALAMITOS, CA, USA,IEEE COMPUT. SOC, US, 11. März 1996 (1996-03-11), Seiten 428-434, XP010159565 ISBN: 0-8186-7423-7**
- **DILILLO L ET AL: "Comparison of open and resistive-open defect test conditions in SRAM address decoders" TEST SYMPOSIUM, 2003. ATS 2003. 12TH ASIAN 16-19 NOV. 2003, PISCATAWAY, NJ, USA,IEEE, 16. November 2003 (2003-11-16), Seiten 250-255, XP010672494 ISBN: 0-7695-1951-2**
- **NADEAU-DOSTIE B ET AL: "SERIAL INTERFACING FOR EMBEDDED-MEMORY TESTING" IEEE DESIGN & TEST OF COMPUTERS, IEEE SERVICE CENTER, NEW YORK, NY, US, Bd. 7, Nr. 2, April 1990 (1990-04), Seiten 52-63, XP000159643 ISSN: 0740-7475**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**Stand der Technik**

Die vorliegende Erfindung betrifft ein Verfahren zum Prüfen eines Adressdecoders eines Datenspeichers auf Funktionsfähigkeit sowie einen Datenträger, der das Verfahren verkörpernde, von einer programmgesteuerten Schaltung ausführbare Programmanweisungen enthält.

Fehler im Decoder eines adressierbaren Speicherbausteins können eine verheerende Auswirkung in sicherheitskritischen Anwendungen haben, wenn z.B. infolge eines solchen Fehlers der Inhalt einer anderen als der adressierten Speicherzelle ausgegeben wird, oder wenn eine Speicherzelle unbeabsichtigt überschrieben wird. Solche Fehler müssen daher so schnell wie möglich nach ihrem Auftreten erfasst werden, um in einem solchen Fall die Anwendung anzuhalten oder zumindest besonders sicherheitskritische Funktionen, die von dem Fehler betroffen sein könnten, zu sperren.

Aus DE 43 17 175 A1 ist eine Selbsttesteinrichtung für einen Datenspeicher bekannt, die es erlaubt, einen gleichzeitigen Zugriff auf zwei oder mehr Speicherzellen eines Datenspeichers, der auf eine Funktionsstörung eines zugeordneten Adressdecoders zurückgeht, zu erfassen. Diese herkömmliche Selbsttesteinrichtung ist in der Lage, einen Decoderfehler unmittelbar zum Zeitpunkt seines erstmaligen Auftretens zu erfassen. Nachteilig ist jedoch, dass die Selbsttesteinrichtung, da sie auf Auswahlleitungen zwischen dem Adressdecoder und einer Speichermatrix des Datenspeichers zugreift, zusammen mit dem Decoder und der Speichermatrix auf einem gleichen Halbleitersubstrat integriert sein muss. Da die Selbsttesteinrichtung über für sie spezifische Schaltungskomponenten verfügt, belegt sie Platz auf dem Halbleitersubstrat, was die Kosten eines mit einer Selbsttesteinrichtung versehenen Datenspeichers erhöht. Dieser inhärente Kostennachteil führt dazu, dass ein solcher Datenspeicher nur in speziellen, ein hohes Maß an Sicherheit erfordernden Anwendungen eingesetzt wird. Er wird daher in deutlich kleineren Stückzahlen gefertigt werden als ein ansonsten vergleichbarer Datenspeicher ohne die Selbsttesteinrichtung, so dass der Kostennachteil des Datenspeichers mit der Selbsttesteinrichtung deutlich stärker ist, als dem Mehrverbrauch an Substratfläche durch die Selbsttesteinrichtung entspricht.

Es besteht daher Bedarf nach Lösungen, die es erlauben, einen Adressdecoder eines Datenspeichers zu überprüfen, ohne dass hierfür spezialisierte Schaltungsbestandteile erforderlich sind.

Eine bekannte Lösung beruht darin, bei einem Adressdecoder von n Bit Breite alle $2^n$ unterschiedlichen Adressen, die mit den n Adressbits darstellbar sind, der Reihe nach als eine Basisadresse zu wählen, den Wert 1 an die Basisadresse zu schreiben, an alle Hamming-Adressen zu dieser Basisadresse, d.h. an diejenigen Adressen, die sich von der Basisadresse in genau einem Bit unterscheiden, den Wert 0 zu schreiben und zu prüfen, ob sich der Wert der Basisadresse verändert hat. Nachteilig an diesem Verfahren ist, dass der Dateninhalt des geprüften Speichers nach der Prüfung zerstört ist. Ein solches Verfahren ist anwendbar beim Start einer Anwendung, bevor der Speicher mit relevanten Daten beschrieben wird, führt dann aber zu einer lästigen Startverzögerung der Anwendung. Um die Startverzögerung zu vermeiden und um Fehler zu erkennen, die bei laufender Anwendung auftreten, wäre es wünschenswert einen Test in Echtzeit durchzuführen, während die Anwendung läuft. Zur Durchführung in Echtzeit ist der oben beschriebene Test aber nur geeignet, wenn bekannt ist, dass der Inhalt des Datenspeichers nicht mehr benötigt ist, was nur in Ausnahmefällen der Fall sein wird.

Selbst wenn zusätzlich Speicherplatz zur Verfügung steht, an den der Inhalt des zu überprüfenden Datenspeichers zwischenzeitlich gesichert werden kann, um ihn später wiederherzustellen, muss sichergestellt sein, dass genügend Zeit zur Ausführung des Tests zur Verfügung steht, denn wenn der Test abgebrochen werden muss, um den Normalbetrieb der Anwendung wieder aufzunehmen, wird in jedem Fall Zeit benötigt, um den ursprünglichen Inhalt des Datenspeichers wiederherzustellen, Zeit, die bei Echtzeitanwendungen nicht immer zur Verfügung steht.

Aus der Druckschrift Sachdev M, ISBN 0-8186-7423-7 sind Test- und Testbarkeitstechniken für "stuck-open" Fehler in RAM Adressdecodern bekannt.

Die EP 1001432 A1 offenbart eine Methode zum Testen von RAM durch Invertierung.

Aus der Druckschrift Dillillo L et. al., ISBN 0-7695-1951-2 ist der Vergleich von Testbedingungen für "stuck-open" Fehler und resistive "stuck-open" Fehler in SRAM Adressdecodern bekannt

Aus der Druckschrift Nadeau-Dostie B et. al., ISSN 0740-7475 ist die serielle Kopplung für das Testen von eingebettetem Speicher bekannt.

Vorteile der Erfindung

Durch die vorliegende Erfindung wird ein Verfahren zum Prüfen eines Adressdecoders geschaffen, das keine spezialisierten Schaltungskomponenten im zu prüfenden Datenspeicher erfordert und deshalb allgemein auf beliebige Typen von Datenspeichern anwendbar ist, und das in kurzen Zeitabständen unterbrechbar ist und sich deshalb gut zur Anwendung in einem Echtzeit-System eignet, in welchem die zur Durchführung des Verfahrens verfügbare Zeit nicht exakt im vorhinein bestimmbar ist.

Das erfindungsgemäße Verfahren beruht allgemein darin, dass aus einem Satz von Adressen des Datenspeichers, als Basisadressen bezeichnet, nacheinander jede Basisadresse ausgewählt wird und für die jeweils ausgewählte Basisadresse folgende Schritte ausgeführt werden:

a) Bestimmen des Inhalts der Basisadresse;

b) Wählen einer Adresse mit dem Hamming-Abstand 1 von der Basisadresse, als Hamming-Adresse bezeichnet;

c) Verändern des Inhalts der in Schritt b) gewählten Hamming-Adresse;

d) Lesen der Basisadresse und Erkennen eines Fehlers des Adressdecoders, wenn der gelesene Inhalt sich von dem in Schritt a) bestimmten unterscheidet; und

e) Wiederherstellen des Inhalts der Hamming-Adresse.

Ein Decoderfehler, der beim Selektieren einer Hamming-Adresse gleichzeitig zum Zugriff auf die Basisadresse führt, ist daran erkennbar, dass in Schritt d) eine Veränderung des Inhalts der Basis-adresse festgestellt wird, die bei ordnungsgemäßem Funktionieren nicht auftreten dürfte. Da die Schritte a) bis e) für jede Basisadresse der Reihe nach ausgeführt werden, ist nach Verarbeitung einer Basisadresse zumindest der Inhalt der Hamming-Adressen originalgetreu wiederhergestellt, und es bedarf, um das erfindungsgemäße Verfahren unterbrechen zu können, höchstens der Wiederherstellung des Inhalts der Basisadresse, wenn dieser durch den Schritt a) des Bestimmens verändert worden ist. Wie später genau erläutert wird, gibt es Ausgestaltungen des Verfahrens, bei denen eine solche Veränderung stattfindet, und andere, die ohne Veränderung auskommen.

Wenn sowohl die Veränderung der Hamming-Adresse in Schritt c) als auch deren Wiederherstellung in Schritt e) im Störungsfall zu einer Veränderung des Inhalts der Basisadresse führen kann, ist es zweckmäßig, den Schritt d) des Lesens der Basisadresse und des Erkennens eines Fehlers sowohl vor dem Wiederherstellen der herstellen des Inhalts der Hamming-Adresse in Schritt e) durchzuführen, als auch einen entsprechenden Schritt f) des Lesens und Fehlererkennens nach der Wiederherstellung vorzunehmen.

Diese Vorgehensweise ist zweckmäßig, wenn das Verändern und das Wiederherstellen des Inhalts der Hamming-Adresse jeweils durch Invertieren erfolgt. Das Verändern und Wiederherstellen durch Invertieren ist allgemein zweckmäßig, da es keine Sicherung des Inhalts der Hamming-Adressen an einem anderen Speicherplatz erfordert und folglich solcher Speicherplatz nicht bereit gehalten zu werden braucht und keine Zeit für das Sichern und Zurückschreiben des Inhalts der Hamming-Adressen aufgewandt werden muss.

Die Schritte b) bis f) werden zweckmäßigerweise jeweils für eine Mehrzahl von der Basisadresse zugeordneten Hamming-Adressen, vorzugsweise die Gesamtheit dieser Hamming-Adressen, wiederholt.

Anstatt durch Invertieren kann das Verändern des Inhalts der Hamming-Adresse auch durch Sichern ihres ursprünglichen Inhalts und Überschreiben mit einem vorgegebenen Wert und das Wiederherstellen durch Zurückschreiben des gesicherten Werts an die Hamming-Adresse erfolgen. Sofern dies für alle Hamming-Adressen, die in Zusammenhang mit einer Basis-adresse verarbeitet werden, sukzessive geschieht, wird jederzeit nur ein einziger Speicherplatz zum Sichern benötigt. Dieser kann evtl. Zeit sparend in Form eines Registers eines Mikroprozessors oder einer anderen programmgesteuerten Schaltung, die das erfindungsgemäße Verfahren ausführt, bereitgestellt werden.

Es kann auch zweckmäßig sein, den Schritt d) des Lesens der Basisadresse und evtl. des Erkennens eines Fehlers erst auszuführen, nachdem der Schritt c) des Veränderns des Inhalts der Hamming-Adresse für eine Mehrzahl von der untersuchten Basisadresse zugeordneten Hamming-Adressen durchgeführt worden ist. Wenn nämlich in Schritt c) jede Hamming-Adresse auf den gleichen Wert geändert wird, kann eine einmal aufgetretene Verfälschung des Inhalts der Basisadresse nicht durch Verändern des Inhalts weiterer Hamming-Adressen rückgängig gemacht werden. Es genügt daher im Extremfall, den Schritt d) ein einziges Mal auszuführen, nachdem Schritt c) für alle zu einer gegebenen Basisadresse zu untersuchenden Hamming-Adressen durchgeführt worden ist, um eine Störung des Decoders zu erkennen. Um den ursprünglichen Inhalt dieser Hamming-Adressen wieder herzustellen, bevor das Verfahren beendet oder eine weitere Basisadresse geprüft wird, werden diese ursprünglichen Inhalte zweckmäßigerweise vor dem Überschreiben des Schritts c) zwischengespeichert.

Einer ersten Ausgestaltung des Verfahrens zufolge ist das Bestimmen des Inhalts der Basisadresse in Schritt a) ein einfaches Lesen der Basisadresse. D.h., das Verfahren ist in der Lage, mit jedem beliebigen Wert zu arbeiten, den die Basisadresse enthält, bevor sie durch das Verfahren bearbeitet wird. Alternativ ist aber auch möglich, den Wert der Basisadresse zu bestimmen, indem ein vorgegebener Wert an die Basisadresse geschrieben wird, und einen zuvor gesicherten ursprünglichen Inhalt der Basisadresse an die Basisadresse zurückzuschreiben, wenn die Schritte b) bis e) für jede zu der Basis-adresse zu untersuchende Hamming-Adresse durchgeführt worden sind.

Der Satz der Basisadressen kann alle Adressen im Adressraum des Datenspeichers umfassen. Wenn der Datenspeicher einen aus Zeilendecoder und Spaltendecoder zusammengesetzten Adressdecoder besitzt, die jeweils einen Zeilenteil bzw. einen Spaltenteil einer Adresse verarbeiten, so ist es möglich, das Verfahren erheblich abzukürzen, indem der Satz von Adressen so gewählt wird, dass jeder mögliche Wert eines der beiden Teile in dem Satz wenigstens einmal, vorzugsweise genau einmal, vertreten ist. M.a.W. kann der Zeilendecoder mit Hilfe eines Satzes geprüft werden, dessen Adressen sich nur in den Bits des Zeilenteils unterscheiden, und der Spaltendecoder kann mit Hilfe eines Satzes geprüft werden, dessen Adressen sich nur in den Bits des Spaltenteils unterscheiden.

Weitere Merkmale und Vorteile der Erfindung ergeben sich aus der nachfolgenden Beschreibung von Ausführungsbeispielen unter Bezugnahme auf die beigefügten Figuren.

Figuren

Fig. 1 zeigt ein Blockdiagramm eines Datenspeichers, an dem die vorliegenden Erfindung anwendbar ist;

Fig. 2 zeigt ein Detail des Datenspeichers aus Fig. 1; und

Fig. 3 und 4 zeigen jeweils Flussdiagramme von an dem Datenspeicher ausführbaren Prüfverfahren.

Beschreibung der Ausführungsbeispiele

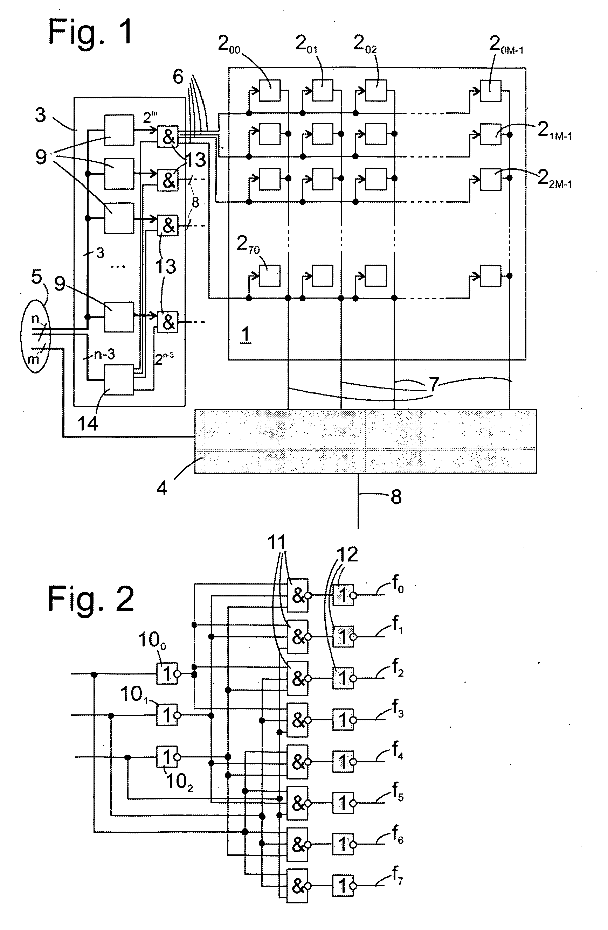

Der in Fig.1 gezeigte Datenspeicher ist an sich bekannt, seine Beschreibung an der Stelle soll lediglich das Verständnis des daran ausführbaren erfindungsgemäßen Prüfverfahrens erleichtern.

Der in Fig. 1 gezeigte Datenspeicher setzt sich im wesentlichen zusammen aus einer Speichermatrix 1 mit $2^{n+m}$ Speicherzellen $2_{ij}$, i=0, ...., $2^{n-1}$ , j=0, ..., $2^{m-1}$ , die in 2" Zeilen und $2^m$ Spalten angeordnet sind, und einem Adressdecoder, der sich aus einem Zeilendecoder 3 und einem Spaltendecoder 4 zusammensetzt. Der Adressdecoder ist an einen Adressbus 5 von n+m Bit Breite angeschlossen, dessen n höherwertige Bits vom Zeilendecoder 3 empfangen werden und dessen m niedrigerwertige Bits vom Spaltendecoder 4 empfangen werden. Dementsprechend werden die n höherwertigen Bits einer auf dem Adressbus 5 vorliegenden Adresse auch als Zeilenteil oder Zeilenadresse und die m niedrigerwertigen Bits als Spaltenteil oder Spaltenadresse bezeichnet.

Der Zeilendecoder 3 hat $2^n$ Ausgänge, an die jeweils eine Auswahlleitung 6 der Speichermatrix 1 angeschlossen ist. Wenn der Zeilendecoder 3 ordnungsgemäß funktioniert, aktiviert er bei jedem Schreib- oder Lesezugriff auf den Datenspeicher 2 genau eine Auswahlleitung 6, die dem Zahlenwert der auf dem Adressbus 5 empfangenen Zeilenadresse i zugeordnet ist. Bei einem Lesezugriff auf die Speicherzelle $2_{ij}$ werden alle an die i-te Auswahlleitung 6 angeschlossenen Speicherzellen $2_{i0}$,...,$2_{iM-1}$, M=$2^m$ veranlasst, ihren Inhalt auf jeweils eine von $2^m$ Spaltenleitungen 7 auszugeben. Der Spaltendecoder 4 selektiert anhand der von ihm empfangenen Spaltenadresse b, Spaltenleitungen 7 entsprechend der Bitbreite b des Datenwortes 8 und verbindet sie bitweise mit den b Datenein-/ausgangsleitungen 8. Bei einem Schreibzugriff gibt der Spaltendecoder 4 einen auf den b Datenein-/ausgangsleitungen 8 empfangenen Datenwert auf die b ausgewählten Spaltenleitungen 7, und die durch die i-te Zeilenleitung selektierten Speicherzellen $2_{ij}$ übernehmen diesen Datenwert als neuen Inhalt.

Der Zeilendecoder 3 ist in Fig. 1 mit einer inneren Struktur dargestellt, auf die im folgenden kurz eingegangen werden soll. Diese Erläuterung soll lediglich dazu dienen, die Störungen zu veranschaulichen, die in dem Zeilendecoder 3 auftreten können; das erfindungsgemäße Prüfverfahren ist unabhängig von der inneren Struktur des Zeilendecoders 3 oder des Spaltendecoders 4 anwendbar.

Der Zeilendecoder 3 enthält eine Gruppe von $2^{(n-3)}$- 1-aus-8-Subdecodern 9, die jeweils einen 3 Bit breiten Eingang und acht Ausgangsleitungen aufweisen, von denen je nach Zahlenwert der drei am Eingang empfangenen Bits genau eine aktiv ist. Eine beispielhafte Struktur eines solchen Subdecoders 9 ist in Fig. 2 gezeigt. Er umfasst drei erste Inverter $10_0$, $10_1$, $10_2$, von denen jeder eines der drei Eingangsbits invertiert, NAND-Gatter 11 mit drei Eingängen, wobei jedes NAND-Gatter 11 mit einer anderen Kombination von negierten oder nicht negierten Eingangsbits beschaltet ist, und den NAND-Gattern 11 nachgeschaltete zweite Inverter 12. Jeder Subdecoder 9 hat acht Ausgänge fk, k=0, 1,..., 7, wobei der Wert k jedes Ausgangs dem Binärwert der drei Eingangsbits entspricht, durch die der betreffende Ausgang selektiert wird.

Die acht Ausgänge $f_0$,...,$f_7$ jedes Subdecoders 9 sind mit einem Block 13 von acht AND-Gattern mit je zwei Eingängen verbunden, wobei von den zwei Eingängen jedes Gatters des Blocks 13 einer mit einer der acht Ausgangleitungen des Subdecoders 9 und ein anderer mit einer von $2^{n-3}$ Ausgangsleitungen eines 1-aus-$2^{n-3}$-Subdecoders 14 verbunden ist, dessen Aufbau analog dem der Subdecoder 9 ist.

Eine Störung eines der Subdecoder 9 kann z.B. darin liegen, dass, wenn auf einen Eingabewert Null am Eingang des Inverters $10_2$ der Wert Eins folgt, der aufgrund einer internen Leiterbahnunterbrechung oder dgl. ein dem früheren Ausgabewert Eins entsprechendes Potential an einer Stelle im Inverter gespeichert bleibt und der Ausgang des Inverters $10_2$ auf Eins bleibt, anstatt korrekt auf Null zu gehen. Dies hat zur Folge, dass, wenn z.B. Bitwerte (1, 1, 1) am Eingang des Subdecoders nach Bitwerten (1, 1, 0) anliegen, nicht nur die Ausgangsleitung $f_7$, sondern auch $f_3$ selektiert wird. Dementsprechend werden zwei Auswahlleitungen 6 der Speichermatrix 1 gleichzeitig aktiviert, deren Adresse sich um ein Bit unterscheidet. Ein anderer möglicher Fehlerfall ist eine Störung, bei der ein Ausgang eines der NAND-Gatter 11 fest auf einem logischen Wert liegt oder hochohmig ist. Auch dies führt zur Aktivierung einer zusätzlichen Auswahlleitung 6.

Ähnliche Fehler in einem der AND-Blöcke 13 führen zur gleichzeitigen Aktivierung von zwei Auswahlleitungen oder dazu, dass gar keine Auswahlleitung aktiviert wird.

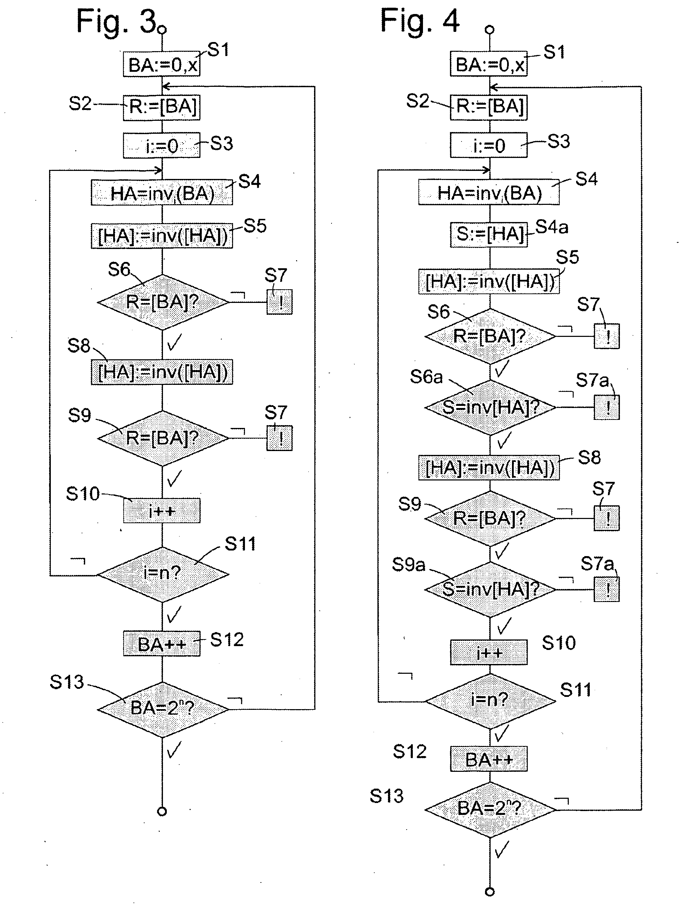

Fig. 3 ist ein Flussdiagramm einer ersten Ausgestaltung des erfindungsgemäßen Verfahrens zum Überprüfen eines Adressdecoders, das an dem oben beschriebenen Datenspeicher anwendbar ist. Das Verfahren wird von einem (nicht gezeigten) Mikroprozessor oder einer anderen programmgesteuerten Schaltung unter Rückgriff auf in einem Festwertspeicher gespeicherte, das Verfahren verkörpernde Programmanweisungen ausgeführt. In Schritt S1 wird eine erste zu überprüfende Basisadresse festgelegt. Wie oben beschrieben, besteht eine Adresse des Datenspeichers jeweils aus einem Zeilenteil und einem Spaltenteil von n bzw. m Bits. Es wird hier der Fall der Überprüfung des Zeilendecoders 3 betrachtet; in diesem Fall wird der Zeilenteil der Adresse auf den Wert 0 und der Spaltenteil auf einen beliebigen Wert x gesetzt.

Als nächstes wird der Inhalt [BA] der durch die Basisadresse BA bezeichneten Speicherzelle in ein Register R gesichert. In Schritt S3 wird ein Zählindex i auf 0 initialisiert.

In Schritt S4 wird eine Hamming-Adresse HA zu der Basisadresse BA ermittelt:

$$HA = inv_i(BA),$$

wobei $inv_i$ für einen Operator steht, der das i-te Bit seines Operanden invertiert und die übrigen Bits unverändert lässt. Der Inhalt [HA] der Hamming-Adresse wird in Schritt S5 gelesen, bitweise invertiert und wieder an der Hamming-Adresse HA gespeichert. Wenn der Zeilendecoder 3 korrekt arbeitet, hat dies keinen Einfluss auf den Inhalt [BA] der Basisadresse BA. Wenn beim Schreiben in Schritt S5 fehlerhaft die Auswahlleitung der Basisadresse BA mit aktiviert wurde, ist deren Inhalt durch inv([HA]) überschrieben.

In Schritt S6 wird geprüft, ob der Inhalt [BA] der Basisadresse BA gleich geblieben ist. Wenn nicht, liegt offensichtlich ein Fehler des Zeilendecoders 3 vor, und eine Fehlerbehandlungsprozedur S7 wird ausgelöst, die z.B. darin beruhen kann, eine Warnmeldung zur Kenntnisnahme durch einen Benutzer auszugeben oder eine Anwendung, die den überprüften Datenspeicher benutzt, zu beenden.

Wenn in Schritt S6 keine Veränderung festgestellt wird, so kann dies auch darauf zurückzuführen sein, dass der in Schritt S5 an die Hamming-Adresse geschriebene Wert zufällig mit dem Inhalt des Registers R übereinstimmt. In Schritt S8 wird der Inhalt [HA] der Hamming-Adresse HA erneut gelesen, invertiert und an dieselbe Adresse zurückgeschrieben. Damit ist der ursprüngliche Inhalt der Hamming-Adresse HA wiederhergestellt, den diese vor Beginn des Verfahrens hatte. Falls im Schritt S6 der Grund für die Nichterkennung eines Fehlers die zufällige Übereinstimmung mit dem Wert des Registers R war, so kann eine solche Übereinstimmung nun nicht mehr vorliegen. Es wird daher in Schritt S9 erneut überprüft, ob der Inhalt [BA] der Basisadresse BA mit dem Register R übereinstimmt. Bei Nichtübereinstimmung wird die gleiche Fehlerbehandlungsroutine S7 wie oben beschrieben ausgelöst. Bei Übereinstimmung wird der Zählindex i in Schritt S10 inkrementiert, und in Schritt S11 wird geprüft, ob i den Wert n erreicht hat, d.h., ob alle n Hamming-Adressen zu der Basisadresse BA überprüft worden sind. Wenn nicht, kehrt das Verfahren zu Schritt S4 zurück, um die nächste Hamming-Adresse zu erzeugen und zu überprüfen; wenn ja, wird in Schritt S12 die Basis-adresse BA inkrementiert. Schritt S13 prüft, ob alle $2^n$ Basisadressen untersucht worden sind. Wenn nein, kehrt das Verfahren zurück zu Schritt S2, um den Inhalt der neuen Basisadresse BA in das Register R zu übernehmen. Wenn ja, ist das Verfahren beendet und der Zeilendecoder 3 als fehlerfrei erkannt.

Das oben beschriebene Prüfverfahren wandelt jeweils nur von Schritt S5 bis Schritt S8 den Inhalt einer einzigen Speicherzelle HA des zu überprüfenden Datenspeichers ab. Folglich kann das Verfahren, wenn es nicht gerade einen der Schritte S5 bis S8 ausführt, jederzeit unterbrochen werden, so dass eine Echtzeitanwendung, die auf den Datenspeicher zugreifen will, allenfalls minimale Verzögerungen hinnehmen muss, bis das Prüfverfahren unterbrochen werden kann und sie den Zugriff auf den Datenspeicher erhält.

Für die Überprüfung einer einzelnen Basisadresse BA werden an Zugriffen auf den Speicher benötigt: ein Lesezugriff im Schritt S2, pro Hamming-Adresse je ein Lese- und Schreibzugriff in Schritt S5, ein Lesezugriff in S6, ein Lese- und Schreibzugriff in S8 und ein Lesezugriff in S9. Der Zeitbedarf dieser Operationen kann jeweils als ein Takt angenommen werden. Jeweils ein weiterer Takt kann für die Vergleichsoperationen in Schritt S6 bzw. S9 erforderlich sein. Die Durchführung der Prüfung erfordert dann insgesamt $2^n \times (1+n \times 7)$ Takte. Der Zeitbedarf für die Überprüfung eines Zeilendecoders mit n=10, z.B. in einem 128kB RAM, beträgt somit $1.024 \times (1+10 \times 7) = 72.704$ Takte, was bei einer angenommenen Taktrate von 40 MHz einem Zeitaufwand von 1,8 ms entspricht. Die Verzögerung, die eine Anwendung durch die Ausführung des erfindungsgemäßen Prüfverfahrens erleidet, beträgt jedoch immer nur wenige Takte, bis zur nächsten zulässigen Unterbrechung. Selbst wenn eine solche Unterbrechung nur nach vollständiger Überprüfung einer Basisadresse zugelassen wird, gibt es $2^n = 1.024$ mögliche Unterbrechungspunkte, so dass die maximale Wartezeit nur 1,8 Mikrosekunden beträgt.

Fig. 4 zeigt eine Abwandlung des mit Bezug auf Fig. 3 beschriebenen Verfahrens, das insbesondere für den Fall zweckmäßig ist, dass im Lesezweig des Datenspeichers, zwischen den Speicherzellen 2 und dem Ausgang, ein Pufferspeicher vorhanden ist, der einen Ausgabedatenwert aufrecht erhält, während in den Speicherzellen bereits das nächste auszugebende Datum selektiert wird. Die Schritte S1 bis S4 sind dieselben wie im Verfahren der Fig. 3. Auf S4 folgt ein Schritt S4a, in welchem der Inhalt der aktuellen Hamming-Adresse HA in ein weiteres Register S gesichert wird. Die Schritte S5 bis S7 sind wieder identisch mit denen der Fig. 3. Wenn in Schritt S6 Übereinstimmung zwischen dem Inhalt der Basisadresse BA und dem Register R festgestellt wird, folgt in Schritt S6a ein Vergleich zwischen dem invertierten Inhalt der Hamming-Adresse HA und dem Register S. Da der Inhalt der Hamming-Adresse HA in S5 bereits einmal invertiert wurde, ist Übereinstimmung zu erwarten; wenn trotzdem eine Nichtübereinstimmung festgestellt wird, kann der Grund darin liegen, dass zwar die Hamming-Adresse HA adressiert wurde, aufgrund eines Fehlers in dem Datenspeicher jedoch noch der in S6 gelesene Inhalt der Basisadresse BA vom Puffer ausgegeben wird, so dass auch in diesem Fall zu einer Fehlerbehandlungsroutine S7a verzweigt wird. Diese kann, da der zugrunde liegende Fehler ein anderer sein kann als der in S6 erkennbare, sich von der Fehlerbehandlungsroutine S7 unterscheiden.

Wenn in S6a Übereinstimmung festgestellt wird, folgen die Schritte S8 des erneuten Invertierens des Inhalts der Hamming-Adresse HA und S9 des Vergleichens des Inhalts der Basisadresse BA mit dem Register R. Wenn in S9 kein Fehler gefunden wird, wird in S9a abermals der invertierte Inhalt der Hamming-Adresse HA mit dem Register S verglichen und bei Nichtübereinstimmung zur Fehlerbehandlungsroutine S7a verzweigt. Bei Übereinstimmung folgen die Schritte S10 bis S13, wiederum wie mit Bezug auf Fig. 3 beschrieben.

Der Zeitbedarf für das Verfahren nach Fig. 4 ist zwar durch die zusätzlichen Lese-, Inversions- und Vergleichsoperationen der Schritte S6a, S9a um mindestens 4 Takte pro Basisadresse größer als bei dem Verfahren nach Fig. 3, doch fällt dies in der Praxis nicht ins Gewicht, da für die Kompatibilität des Prüfverfahrens mit einer gleichzeitig auf den Datenspeicher zugreifenden Anwendung nicht die Gesamtdauer der Prüfung, sondern die maximale Wartezeit zeit bis zu einer möglichen Unterbrechung der Prüfung entscheidend ist.

**Patentansprüche**

1. Verfahren zum Prüfen eines Adressdecoders eines Datenspeichers, bei dem aus einem Satz von Adressen des Datenspeichers, als Basisadressen bezeichnet, nacheinander jede Basisadresse ausgewählt wird (S1) und für die jeweils ausgewählte Basisadresse folgende Schritte ausgeführt werden:

   a) Bestimmen des Inhalts der Basisadresse (S2, S2a); und
   b) Wählen einer Adresse mit Hamming-Abstand 1 von der Basisadresse, als Hamming-Adresse bezeichnet (S4); dann:
   c) Verändern des Inhalts der in Schritt b) gewählten Hamming-Adresse (S5, S5'a); dann:
   d) Lesen der Basisadresse und Erkennen eines Fehlers des Adressdecoders (S6, S6'), wenn der gelesene Inhalt sich von dem in Schritt a) bestimmten unterscheidet; **gekennzeichnet durch**
   e) Wiederherstellen des Inhalts der Hamming-Adresse (S8, S8'),

   wobei auf Schritt d) der Schritt e) und auf Schritt e) ein Schritt:
   f) Lesen der Basisadresse und Erkennen eines Fehlers des Adressdecoders (S9), wenn der gelesene Inhalt sich von dem in Schritt a) gelesenen unterscheidet folgt,
   wobei das Verändern (S5) und das Wiederherstellen (S8) des Inhalts der Hamming-Adresse jeweils **durch** Invertieren erfolgt.

2. Verfahren nach Anspruch 1, **dadurch gekennzeichnet, dass** die Schritte b) bis f) für eine Mehrzahl von der Basisadresse zugeordneten Hamming-Adressen wiederholt werden.

3. Verfahren nach einem der vorhergehenden Ansprüche, **dadurch gekennzeichnet, dass** das Bestimmen des Inhalts der Basisadresse ein Lesen (S2) der Basisadresse ist.

4. Verfahren nach einem der vorhergehenden Ansprüche, **dadurch gekennzeichnet, dass** der Satz der Basisadressen alle Adressen im Adressraum des Datenspeichers umfasst.

5. Verfahren nach einem der Ansprüche 1 bis 4, **dadurch gekennzeichnet, dass** die Adressen des Datenspeichers aus einem ersten und einem zweiten Teil bestehen, und dass der Satz von Adressen jeden möglichen Wert des ersten Teils wenigstens einmal enthält.

6. Verfahren nach einem der vorhergehenden Ansprüche, **dadurch gekennzeichnet, dass** es von einer programmgesteuerten Schaltung ausgeführt wird.

7. Datenträger, **dadurch gekennzeichnet, dass** auf ihm Programmanweisungen aufgezeichnet sind, die eine programmgesteuerte Schaltung befähigen, das Verfahren nach Anspruch 6 auszuführen.

**Claims**

1. Method for testing an address decoder of a data memory, in which, from a set of addresses of the data memory, referred to as base addresses, each base address is selected in succession (81), and the following steps are carried out for the respectively selected base address:

   a) the contents of the base address are determined (S2, S2a); and
   b) an address having a Hamming distance of 1 from the base address, referred to as the Hamming address, is selected (S4); then:
   c) the contents of the Hamming address selected in step b) are changed (S5, S5'a); then:

d) the base address is read and a fault in the address decoder is detected (S6, S6') if the contents which have been read differ from the contents determined in step a); **characterized by**

e) the operation of restoring the contents of the Hamming address (S8, S8'),

step d) being followed by step e) and step e) being followed by a step:

f) the base address is read and a fault in the address decoder is detected (S9) if the contents which have been read differ from the contents read in step a),

the contents of the Hamming address respectively being changed (S5) and restored (S8) by means of inversion.

2. Method according to Claim 1, **characterized in that** steps b) to f) are repeated for a plurality of Hamming addresses assigned to the base address.

3. Method according to one of the preceding claims, **characterized in that** the operation of determining the contents of the base address involves reading (S2) the base address.

4. Method according to one of the preceding claims, **characterized in that** the set of base addresses comprises all addresses in the address space of the data memory.

5. Method according to one of Claims 1 to 4, **characterized in that** the addresses of the data memory consist of a first part and a second part, and **in that** the set of addresses contains each possible value of the first part at least once.

6. Method according to one of the preceding claims, **characterized in that** it is carried out by a program-controlled circuit.

7. Data storage medium, **characterized in that** program instructions which enable a program-controlled circuit to carry out the method according to Claim 6 are recorded on said data storage medium.

## Revendications

1. Procédé de vérification d'un décodeur d'adresses d'une mémoire de données, dans lequel chaque adresse de base est sélectionnée successivement (S1) dans un jeu d'adresses de la mémoire de données appelées adresses de base, les étapes suivantes étant exécutées pour chaque adresse de base sélectionnée :

   a) déterminer le contenu de l'adresse de base (S2, S2a),

b) sélectionner une adresse située à une distance de Hamming 1 de l'adresse de base et appelée adresse de Hamming (S4),

c) ensuite, modifier le contenu de l'adresse de Hamming (S5, S5'a) sélectionnée à l'étape b),

d) ensuite, lire l'adresse de base et détecter une erreur du décodeur d'adresses (S6, S6') lorsque le contenu lu est différent du contenu déterminé à l'étape a),

**caractérisé par** l'étape qui consiste à :

e) rétablir le contenu de l'adresse de Hamming (S8, S8'),

l'étape d) étant suivie par l'étape e) et l'étape e) étant suivie par l'étape qui consiste à

f) lire l'adresse de base et détecter une erreur du décodeur d'adresses (S9) si le contenu lu est différent du contenu lu à l'étape a),

la modification (S5) et le rétablissement (S8) du contenu de l'adresse de Hamming s'effectuant chaque fois par inversion.

2. Procédé selon la revendication 1, **caractérisé en ce que** les étapes b) à f) sont répétées pour plusieurs adresses de Hamming associées à l'adresse de base.

3. Procédé selon l'une des revendications précédentes, **caractérisé en ce que** la détermination du contenu de l'adresse de base est une lecture (S2) de l'adresse de base.

4. Procédé selon l'une des revendications précédentes, **caractérisé en ce que** le jeu d'adresses de base contient toutes les adresses de l'espace d'adresses de la mémoire de données.

5. Procédé selon l'une des revendications 1 à 4, **caractérisé en ce que** les adresses de la mémoire de données sont constituées d'une première et d'une deuxième partie et **en ce que** le jeu d'adresses prend au moins une fois chaque valeur possible de la première partie.

6. Procédé selon l'une des revendications précédentes, **caractérisé en ce qu'**il est exécuté par un circuit commandé par programme.

7. Support de données, **caractérisé en ce que** des indications de programme qui permettent à un circuit commandé par programme d'exécuter le procédé selon la revendication 6 y sont inscrites.

Fig. 1

Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4317175 A1

- EP 1001432 A1